# EUROPÄISCHE PATENTSCHRIFT

(11) **EP 1 719 191 B1**
(45) Veröffentlichungstag und Bekanntmachung des Hinweises auf die Patenterteilung: **29.07.2009**
(21) Anmeldenummer: 05707802.4
(22) Anmeldetag: 19.01.2005
(51) Int. Cl.: H01L 41/22

(54) **VERFAHREN UND VORRICHTUNG ZUR POLARISIERUNG EINES PIEZOELEKTRISCHEN AKTORS**
METHOD AND DEVICE FOR POLARIZING A PIEZOELECTRIC ACTUATOR
PROCEDE ET DISPOSITIF DE POLARISATION D'UN ACTIONNEUR PIEZO-ELECTRIQUE

(30) Priorität: 25.02.2004 DE 102004009140
(43) Veröffentlichungstag der Anmeldung: 08.11.2006
(73) Patentinhaber: Continental Automotive GmbH, 30165 Hannover (DE)
(72) Erfinder: DÖLLGAST, Bernd, 91054 Erlangen (DE); NIEFANGER, Roland, 22761 Hamburg (DE); WITTE, Kord, 09212 Limbach-Oberfrohna (DE)
(86) Internationale Anmeldenummer: PCT/EP2005/050213
(87) Internationale Veröffentlichungsnummer: WO 2005/081332

(56) Entgegenhaltungen:
- WO-A1-99/31739
- DE-A1- 10 028 335

## Beschreibung

Die Erfindung betrifft ein Verfahren zur Polarisierung eines piezoelektrischen Aktors gemäß dem Oberbegriff des Patentanspruchs 1 und eine Vorrichtung zum Polarisieren eines piezoelektrischen Aktors gemäß dem Oberbegriff von Anspruch 9.

Piezoelektrische Aktoren werden in den verschiedensten technischen Bereichen eingesetzt, um Stellglieder zu betätigen. Dabei haben die piezoelektrischen Aktoren den wesentlichen Vorteil, dass eine schnelle Betätigung mit hoher Dynamik und mit hoher Kraft möglich ist.

Ein piezoelektrischer Aktor ist aus einer Vielzahl von piezoelektrischen Schichten aufgebaut. Die einzelnen piezoelektrischen Schichten sind jeweils zwischen zwei Metallelektroden angeordnet. Zur Betätigung des piezoelektrischen Aktors wird an die piezoelektrischen Schichten eine elektrische Spannung angelegt, die zu einer Verlängerung der einzelnen piezoelektrischen Schichten und zu einer Verlängerung des piezoelektrischen Aktors insgesamt führt. Damit die piezoelektrische Schicht nach der Herstellung einen piezoelektrischen Effekt aufweist, bei dem sich die Dicke der piezoelektrischen Schicht bei Anlegen einer elektrischen Spannung verändert, ist es erforderlich, die piezoelektrischen Schichten zuerst zu polarisieren.

Zur Polarisierung der piezoelektrischen Schichten wird ein elektrisches Polarisationsfeld, d.h. eine elektrische Spannung angelegt, wodurch sich eine remanente Polarisation und eine geordnete Verteilung der in den piezoelektrischen Schichten ausgerichteten Domänen in der Feldrichtung des Polarisationsfeldes gegenüber dem unpolarisierten Ausgangszustand ergibt. Nach der Polarisation der piezoelektrischen Schichten sind die piezoelektrischen Schichten remanent, d.h. andauernd in der Richtung des angelegten Polarisationsfeldes verlängert. Die remanente Verlängerung der piezoelektrischen Schichten wird an die Spannungsbedingungen im Einsatz des piezoelektrischen Aktors dadurch angepasst, dass die Polarisation unter einer Druckspannung erfolgt. Dadurch werden Setzeffekte der piezoelektrischen Schichten, die nach der Polarisation auftreten, reduziert. Ein entsprechendes, gattungsgemäßes Verfahren ist aus der Internationalen Patentanmeldung mit der Internationalen Veröffentlichungsnummer WO 99/31739 bekannt. Polarisierung mit Spannungspulsen ist insbesondere aus der DE 100 28 335 A1 bekannt.

Zur Polarisierung des piezoelektrischen Aktors werden zeitlich veränderliche Spannungen verwendet, da dadurch eine verbesserte Polarisation erreicht wird. Die Länge des piezoelektrischen Aktors ändert sich während des Polarisationsvorganges entsprechend den angelegten Spannungspulsen. Da der piezoelektrische Aktor zur Darstellung der Druckspannung zwischen zwei Halterungen eingespannt ist, wird die von den Halterungen auf dem piezoelektrischen Aktor erzeugte Druckspannung durch die Längenänderung des piezoelektrischen Aktors verändert. Dadurch wird der Polarisationsvorgang des piezoelektrischen Aktors negativ beeinflusst.

Die Aufgabe der Erfindung besteht darin, ein Verfahren und eine Vorrichtung zur Polarisierung eines piezoelektrischen Aktors bereitzustellen, mit dem eine Verbesserung des Polarisierungsvorganges möglich ist.

Die Aufgabe der Erfindung wird durch das Verfahren gemäß Patentanspruch 1 und durch die Vorrichtung gemäß Patentanspruch 9 gelöst.

Weitere vorteilhafte Ausführungsformen der Erfindung sind in den abhängigen Ansprüchen angegeben.

Ein Vorteil der Erfindung besteht darin, dass die Vorspannkraft während der Polarisation im Wesentlichen konstant gehalten wird. Dazu ist zwischen dem ersten piezoelektrischen Aktor und der Vorspannhalterung ein zweiter piezoelektrischer Aktor angeordnet, der einen Längenausgleich bei der Polarisation des ersten piezoelektrischen Aktors bewirkt. Dadurch wird sichergestellt, dass die Gesamtlänge der zwei piezoelektrischen Aktoren im Wesentlichen konstant bleibt. Somit kann die Lage der Halteelemente der Vorspannhalterung nach einer Startphase im Wesentlichen konstant gehalten werden.

Der zweite piezoelektrische Aktor wird dabei phasenverschoben zum ersten piezoelektrischen Aktor mit einer sich ändernden Spannung versorgt, wobei nach einer Startphase, in der die Amplituden der Spannungen erhöht werden, die zwei Spannungen in der Weise festgelegt werden, dass die Summe der Spannungen annähernd konstant bleibt. Auf diese Weise wird erreicht, dass die Gesamtlänge der zwei piezoelektrischen Aktoren während des Polarisierungsvorganges im Wesentlichen konstant bleibt. Dadurch ist es möglich, eine konstante Vorspannkraft bei Beginn des Polarisationsvorganges an die zwei piezoelektrischen Aktoren durch eine Lagejustierung der Halteelemente der Vorspannhalterung festzulegen, ohne dass es erforderlich ist, die Lage der Halteelemente der Vorspannhalterung nach der Startphase während der Polarisation des ersten und/oder des zweiten Aktors verändern zu müssen.

Aufgrund des erfindungsgemäßen Verfahrens ist es möglich, die Spannungen, die zur Polarisation der piezoelektrischen Aktoren verwendet werden, mit einer hohen Frequenz anzulegen. Da die piezoelektrischen Aktoren eine hohe Dynamik bei der Längenänderung aufweisen, ist es möglich, die schnellen Längenänderungen des ersten piezoelektrischen Aktors durch eine entsprechend schnelle Längenänderung des zweiten piezoelektrischen Aktors auszugleichen. Entsprechend hohe Frequenzen könnten mit einer Lageänderung der Halteelemente nicht erreicht werden, da deren Massenträgheit eine entsprechende dynamische Bewegung nicht zulässt.

Vorzugsweise werden die Spannungen, die an die zwei Aktoren gleichzeitig angelegt werden, in der Weise festgelegt, dass die Erhöhung bzw. Erniedrigung der Spannung an den Elektroden des ersten Aktors gleich der Erniedrigung bzw. der Erhöhung der Spannung an den Elektroden des zweiten Aktors ist. Auf diese Weise wird die auf die piezoelektrischen Schichten der zwei Aktoren wirkenden Spannungsänderungen gleich groß gewählt.

In einer weiteren Ausführungsform des erfindungsgemäßen Verfahrens wird die Längenänderung des ersten und/oder des zweiten piezoelektrischen Aktors während einer Startphase durch eine Lageänderung der Halteelemente der Vorspannhalterung während des Polarisierungsvorganges ausgeglichen. Auch auf diese Weise wird die Druckspannung, die auf die piezoelektrischen Aktoren während des Polarisationsvorganges einwirkt, trotz der Längenänderung annähernd konstant gehalten.

Die erfindungsgemäße Vorrichtung weist den Vorteil auf, dass die während eines Polarisationsvorganges eines ersten piezoelektrischen Aktors auftretenden hoch dynamischen Längenänderungen präzise durch einen zweiten piezoelektrischen Aktor ausgeglichen werden, so dass die während des Polarisationsvorganges auf den ersten und/oder den zweiten piezoelektrischen Aktor einwirkende Vorspannkraft im Wesentlichen konstant gehalten wird. Dazu weist die Vorrichtung ein Steuergerät auf, das die Polarisation des ersten und des zweiten Aktors in der Weise durchführt, dass die durch die Polarisation im ersten Aktor erzeugte Längenänderung durch die durch die Polarisation im zweiten Aktor erzeugte Längenänderung ausgeglichen wird.

In einer weiteren bevorzugten Ausführungsform ist wenigstens ein Halteelement der Vorspannvorrichtung, das zur Halterung des piezoelektrischen Aktors dient, bewegbar gehaltert und dessen Lage wird von der Steuereinheit in entsprechender Weise geändert, um während der Startphase auftretende Längenänderungen der piezoelektrischen Aktoren auszugleichen.

Die Erfindung wird im Folgenden anhand der Figuren näher erläutert. Es zeigen
Fig. 1 den schematischen Aufbau eines piezoelektrischen Aktors,
Fig. 2 eine Vorrichtung zur Polarisierung eines piezoelektrischen Aktors,
Fig. 3 Kennlinien eines ersten Polarisationsverfahrens, und
Fig. 4 Kennlinien eines zweiten Polarisationsverfahrens.

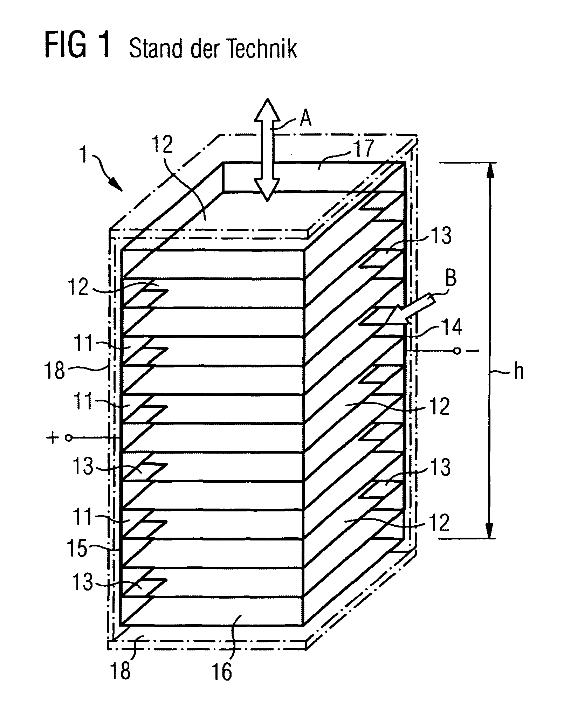

Fig. 1 zeigt den schematischen Aufbau eines piezoelektrischen ersten Aktors 1, der aus einer Vielzahl von piezoelektrischen Schichten 11 besteht. Die piezoelektrischen Schichten 11 sind in Form eines Schichtstapels übereinander angeordnet, wobei jeweils eine piezoelektrische Schicht 11 von zwei flächigen Elektroden 12 begrenzt ist. Somit ist zwischen zwei piezoelektrischen Schichten 11 jeweils eine Elektrode 12 angeordnet. Der Schichtstapel ist am unteren Ende von einer ersten Abdeckplatte 16 und am oberen Ende von einer zweiten Abdeckplatte 17 begrenzt. Die zwei Abdeckplatten 16, 17 sind zwischen eine hülsenförmige Rohrfeder 18 eingespannt, die in der Fig. 1 nur schematisch angedeutet ist. Die Rohrfeder 18 spannt die erste und die zweite Abdeckplatte 16, 17 in Richtung auf den Schichtstapel von piezoelektrischen Schichten 12 vor. In Abhängigkeit von der gewünschten Ausführungsform kann auf die Rohrfeder 18 auch verzichtet werden.

Die Elektroden 12 sind im Wesentlichen entsprechend der Flächenform der piezoelektrischen Schichten 12 ausgebildet. Die Elektroden 12 sind abwechselnd an einen ersten oder einen zweiten Leiter 14, 15 angeschlossen. Der erste und der zweite Leiter 14, 15 sind an gegenüberliegenden Eckbereichen des Schichtstapels angeordnet. Damit nicht jede Elektrode 12 mit jedem ersten und zweiten Leiter 14 und 15 kontaktiert ist, sind entsprechende Aussparungen 13 vorgesehen, so dass eine Elektrode 12 nur mit einem ersten oder zweiten Leiter 14, 15 elektrisch leitend kontaktiert ist. Die Aussparungen befinden sich angrenzend an den ersten oder den zweiten Leiter 14, 15 im Bereich der Elektroden 12. Auf diese Weise wird sichergestellt, dass eine piezoelektrische Schicht 11 zwischen zwei Elektroden 12 angeordnet ist, die mit dem ersten bzw. dem zweiten Leiter 14, 15 elektrisch leitend verbunden sind. Wird nun an den ersten und den zweiten Leiter 14, 15 eine Spannung angelegt, so wird die Spannung an jeweils zwei Elektroden 12 einer piezoelektrischen Schicht 11 angelegt. Damit stellt der Schichtstapel mit den piezoelektrischen Schichten 11 eine Serienschaltung von einer Vielzahl von piezoelektrischen Schichten dar. Der Schichtstapel stellt einen monolithisch ausgebildeten Vielschichtpiezoaktor dar.

Der erste Aktor 1 kann beispielsweise als Ventilantrieb verwendet werden und hat eine Betriebsdauer, die 10⁹ Betriebszyklen überschreiten kann. Die Elektroden 12 sind vorzugsweise als Metallelektroden ausgebildet. Der erste und der zweite Leiter 14, 15 werden zuerst für eine Polarisierung der piezoelektrischen Schichten 12 und anschließend zum Betrieb des Aktors 1 verwendet. Um mit dem ersten Aktor Arbeitshübe von 5 bis 60 µm erreichen zu können, ist eine Stapelhöhe von 5 bis 40 mm erforderlich, was einer Anzahl von bis zu 1000 piezoelektrischen Schichten 11 entspricht.

Nach der Herstellung des Schichtstapels weisen die gesinterten Keramikkörner der piezoelektrischen Schichten 11 spontane Polarisationsbereiche mit unterschiedlichen Polarisationsrichtungen auf. Die spontane Polarisation ist mit einer Deformation des Kristallgitters verbunden. Auftretende innere Spannungen können teilweise nur durch die Ausbildung von Domänen abgebaut werden. Nach der spontanen Polarisation sind die Dipolmomente der einzelnen Domänen so ausgerichtet, dass sie sich aufgrund der statistisch verteilten Polarisationsrichtungen kompensieren.

Für die Bereitstellung von nutzfähigen Arbeitshüben ist es erforderlich, die Polarisationsrichtungen der Dipolmomente der einzelnen Domänen in einer Richtung auszurichten. Die Ausrichtung der Dipolmomente wird dadurch erreicht, dass ein elektrisches Polarisationsfeld an die piezoelektrischen Schichten 11 angelegt wird, wodurch eine Polarisation der Dipolmomente der Domänen parallel zur Längsachse des ersten Aktors 1 auftritt, da die Elektroden 12 senkrecht zu der Längsachse des Aktors 1 angeordnet sind. Zudem erfährt der Schichtstapel eine remanente Längenänderung in der Längsachse des Stapels. Zur Verbesserung des Polarisationsverfahrens wird der Schichtstapel bestehend aus den piezoelektrischen Schichten 11 unter einer festgelegten Druckspannung dem Polarisationsfeld ausgesetzt und polarisiert. Das Polarisationsfeld wird durch das Anlegen einer Polarisationsspannung an den ersten und den zweiten Leiter 14, 15 erzeugt. Wahlweise kann eine Polarisationstemperatur von 20 bis 150°C eingestellt werden. Typischerweise werden elektrische Polarisationsfelder verwendet, die eine Stärke von 2 bis 2,5 kV/mm aufweisen. Während der gesamten Polarisationszeit wird das Polarisationsfeld und die Druckspannung aufrechterhalten. Für typische Polarisationsvorgänge sind Polarisationszeiten im Bereich von einigen Minuten üblich.

Versuche haben gezeigt, dass piezoelektrische Aktoren 1 mit besonders guten Eigenschaften dadurch hergestellt werden können, dass die Polarisation der piezoelektrischen Schichten 11 des piezoelektrischen Aktors 1 mit veränderlichen Polarisationsfeldern erzeugt wird. Dabei werden während eines Polarisationsverfahrens mehrere Spannungspulse in Folge in Form von Kennlinien mit sich ändernden Amplituden angelegt. Während eines Polarisationsverfahrens wird durch die sich ändernde Spannung ein sich änderndes elektrisches Polarisationsfeld an die piezoelektrischen Schichten 11 angelegt. Die Amplitude der Kennlinien der Spannungen kann einen sinusförmigen, einen rechteckförmigen oder auch andere Spannungsverläufe mit sich ändernden Amplituden aufweisen. Bei dieser Vorgehensweise besteht jedoch ein Problem darin, die auf den Schichtstapel einwirkende Druckspannung in festgelegten Bereichen zu halten. Dies ist deshalb schwierig, da bei dem Polarisationsverfahren der piezoelektrische Aktor entsprechend der sich ändernden Spannung seine Länge verändert.

Die auf den piezoelektrischen Aktor 1 einwirkende Druckspannung sollte in einem festgelegten Bereich liegen, einen gewissen Maximalwert nicht überschreiten und einen gewissen Minimalwert nicht unterschreiten, um die Güte des polarisierten Aktors 1 nicht zu beeinträchtigen. Die Längenänderung des piezoelektrischen Aktors 1 erfordert es im Stand der Technik, dass der Abstand der Halteelemente, zwischen die der piezoelektrische Aktor 1 beim Polarisierungsvorgang eingespannt ist, variiert wird, damit die auf den piezoelektrischen Aktor 1 einwirkende Druckspannung in dem gewünschten Spannungsbereich bleibt. Mit zunehmender Frequenz der Spannung, die während des Polarisierungsvorganges an die piezoelektrischen Schichten 11 angelegt wird, ist die Abstandsänderung zwischen den zwei Halteelementen der Spanneinrichtung immer schwieriger einzuhalten. Aufgrund der Massenträgheit der Halteelemente kann eine präzise Einstellung der Vorspannkraft während des Polarisationsvorganges bei hohen Frequenzen der Polarisationsspannungen nicht mehr eingehalten werden.

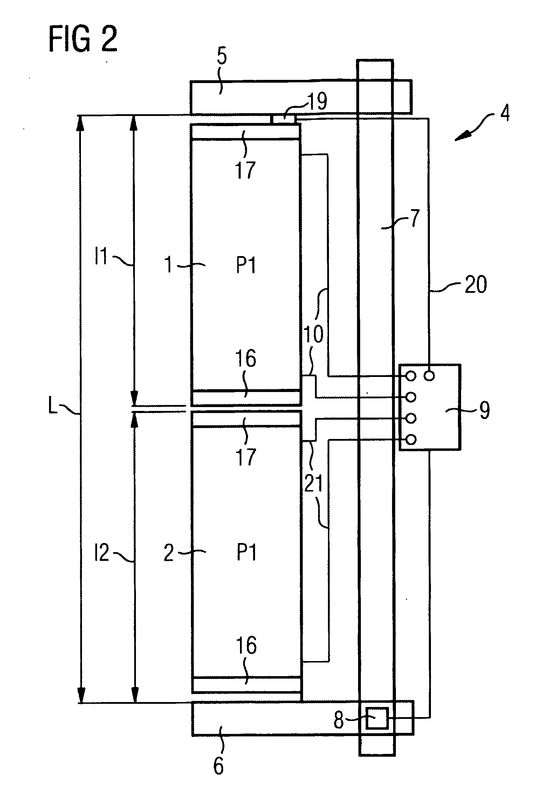

Die Erfindung schlägt ein verbessertes Polarisationsverfahren und eine verbesserte Vorrichtung zur Durchführung des Polarisationsverfahrens vor, die anhand der Fig. 2 näher erläutert werden. In Abhängigkeit von der gewählten Ausführung wird der erste Aktor 1 vor oder nach dem Einbringen in die Rohrfeder 18 polarisiert.

Fig. 2 zeigt in einer schematischen Darstellung eine Vorspannhalterung 4, die zwei Halteelemente 5, 6 aufweist, die den ersten und zweiten piezoelektrischen Aktor 1, 2 während des Polarisationsvorganges mit einer einstellbaren Vorspannkraft beaufschlagen. Die Halteelemente 5, 6 stehen über ein Gehäuse 7 miteinander in Wirkverbindung. In der dargestellten Ausführungsform ist das erste Halteelement 5 fest mit dem Gehäuse 7 verbunden. Das zweite Halteelement 6 ist über eine Mechanik 8 bewegbar am Gehäuse 7 gehaltert. Die Mechanik 8 ist in dem dargestellten Ausführungsbeispiel als Motor mit Schneckengetriebe ausgebildet. Durch eine entsprechende Ansteuerung des Motors 8 kann die Lage des zweiten Halteelementes 6 entlang der Längsrichtung des Gehäuses 7 verschoben werden. Damit wird der Abstand L zwischen den zwei Halteelementen 5, 6 verändert.

Der Motor 8 ist über Steuerleitungen mit einer Steuereinheit 9 verbunden. Die Steuereinheit 9 steht über erste Steuerleitungen 10 mit dem ersten Aktor 1 in Verbindung. Die ersten zwei Steuerleitungen 10 sind an den ersten bzw. den zweiten Leiter 14, 15 des ersten Aktors 1 angeschlossen. Der erste Aktor 1 ist in der Längsrichtung parallel zum Gehäuse 7 angeordnet und liegt mit der zweiten Abdeckplatte 17 am ersten Halteelement 5 an. In einer bevorzugten Ausführungsform ist zwischen dem ersten Halteelement 5 und der zweiten Abdeckplatte 17 des ersten Aktors 1 ein Drucksensor 19 angeordnet. Der Drucksensor 19 ist über eine Signalleitung 20 mit der Steuereinheit 9 verbunden. Der Drucksensor 19 erfasst die Vorspannkraft, die von der Vorspannhalterung 4 auf den ersten und zweiten Aktor 1, 2 ausgeübt wird.

In dem dargestellten Ausführungsbeispiel ist der zweite Aktor 2 zwischen dem ersten Aktor 1 und dem zweiten Halteelement 6 angeordnet. Der zweite Aktor 2 ist vorzugsweise identisch zum ersten Aktor 1 ausgebildet. Vorzugsweise ist eine zweite Länge 12 des zweiten Aktors 2 gleich einer ersten Länge 11 des ersten Aktors 1. Der zweite Aktor 2 ist über zwei zweite Steuerleitungen 21 an die Steuereinheit 9 angeschlossen. Eine der zweiten Steuerleitungen 21 ist an den ersten Leiter 14 und die andere zweite Steuerleitung 21 ist an den zweiten Leiter 15 angeschlossen.

Für die Durchführung eines Polarisationsvorganges legt die Steuereinheit 9 eine festgelegte Vorspannkraft in Längsrichtung an den ersten und den zweiten Aktor 1, 2 dadurch an, dass das zweite Halteelement 6 über den Motor 8 in entsprechender Weise in Richtung auf das erste Halteelement 5 bewegt wird. In Abhängigkeit davon, ob der Drucksensor 19 vorgesehen ist oder nicht, werden entweder experimentell ermittelte Verfahrwege des zweiten Halteelementes 6 zur Ansteuerung des Motors 8 verwendet oder die Steuereinheit 9 erfasst während des Verfahrens des zweiten Halteelementes 6 über den Drucksensor 19 die auf den ersten und den zweiten Aktor einwirkende Vorspannkraft und verfährt das zweite Halteelement 6 so lange, bis die gewünschte Vorspannkraft am ersten und am zweiten Aktor 1, 2 anliegt.

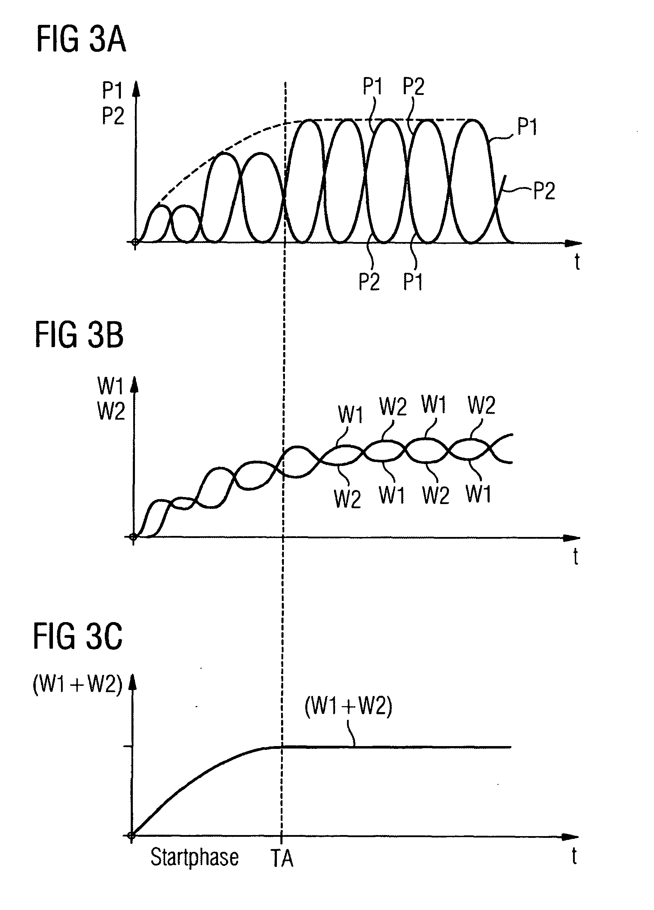

Figur 3 zeigt schematische Kennlinien eines Polarisationsverfahrens der zwei Aktoren mit einer Startphase. In Figur 3a sind die Polarisationsspannungen P1,P2 über die Zeit t aufgetragen. In Figur 3b sind die Längenänderungen W1, W2 des ersten und des zweiten Aktors 1,2 über der Zeit t aufgetragen. In Figur 3c ist die Summe der Längenänderungen des ersten und des zweiten Aktors 1,2 über der Zeit t aufgetragen. Die Startphase erstreckt sich vom nullten Zeitpunkt t0 bis zum Anfangszeitpunkt TA der zweiten Phase.

In einer bevorzugten Ausführungsform wird parallel zum Einstellen der Vorspannkraft der erste Aktor 1 während der Startphase mit einer sich ändernden ersten Polarisationsspannung P1 beaufschlagt, deren Amplitude um einen steigenden ersten Mittelwert schwankt. Zudem wird während der Startphase der zweite Aktor mit einer zweiten sich ändernden Polarisationsspannung beaufschlagt, deren Amplitude um einen steigenden zweiten Mittelwert schwankt. Die erste und die zweite Polarisationsspannung sind in der Weise aufeinander abgestimmt, dass die Summe aus der ersten und der zweiten Polarisationsspannung auf einen festgelegten Wert stetig zunimmt. Die erste und die zweite Polarisationsspannung können verschiedene Spannungsverläufe aufweisen. In Figur 3a sind die erste und die zweite Polarisationsspannung in Form von Sinuskurven dargestellt, die um 90° gegeneinander phasenverschoben sind.

Aufgrund der Zunahme des Mittelwertes der ersten Polarisationsspannung P1 während der Startphase verändert sich entsprechend die erste Länge L1 des ersten Aktors 1 um eine erste Längenänderung W1, wie in Figur 3b dargestellt ist. Aufgrund der Zunahme des Mittelwertes der zweiten Polarisationsspannung P2 während der Startphase vergrößert sich entsprechend die zweite Länge L2 des zweiten Aktors 2 um eine zweite Längenänderung W2, wie in Figur 3b dargestellt. Damit nimmt auch folglich die auf den ersten und den zweiten Aktor 1, 2 einwirkende Vorspannkraft unabhängig von der relativen Lage des ersten und des zweiten Halteelementes 5, 6 zu.

Am Ende der Startphase nach dem Anfangszeitpunkt TA der zweiten Phase haben die erste und die zweite Polarisationsspannung P1, P2 einen maximalen Mittelwert erreicht, um den die erste und die zweite Polarisationsspannung P1,P2 schwanken. Die erste und die zweite Polarisationsspannung P1, P2 sind nach der Startphase in der Weise ausgebildet, dass die Summe aus der ersten und der zweiten Polarisationsspannung P1,P2 im wesentlichen zeitlich konstant ist. Da die Summe der Polarisationsspannungen im wesentlichen zeitlich konstant ist, ist auch die Summe der Längenänderungen (W1+W2) des ersten und des zweiten Aktors im wesentlichen zeitlich konstant, wie in Figur 3c dargestellt ist.

Die gewünschte Vorspannkraft wird von der Steuereinheit 9 bei Anliegen einer ersten Polarisationsspannung P1 am ersten Aktor 1 und bei Anliegen einer zweiten Polarisationsspannung P2 am zweiten Aktor 2 durch die Einstellung des Abstandes der Haltelemente 5,6 auf einen gewünschten Wert während der Startphase eingestellt.

Da die Summe der Längenänderungen (W1+W2) der zwei Aktoren 1,2 nach der Startphase im wesentlichen konstant bleibt, ist es trotz der sich um den jeweiligen Mittelwert schwankenden ersten und zweiten Polarisationsspannungen P1,P2 nicht erforderlich, die Abstände zwischen dem ersten und dem zweiten Haltelement zu verändern, um eine maximale Vorspannung des ersten und des zweiten Aktors in einem festgelegten Wertebereich zu halten.

Damit können die erste und die zweite Polarisationsspannung hohe Frequenzen aufweisen, mit denen die erste und die zweite Polarisationsspannung um den jeweiligen Mittelwert schwanken, ohne dass eine Nachregelung des Abstandes des ersten und zweiten Halteelementes erforderlich ist. Die dadurch möglichen hohen Frequenzen sind für die Polarisation des ersten und/oder des zweiten Aktors vorteilhaft.

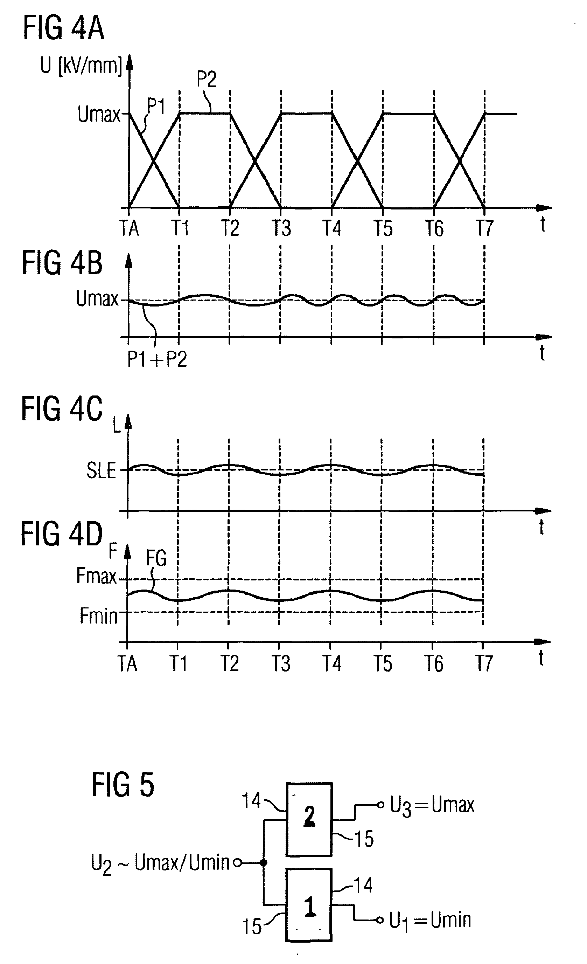

Figur 4 zeigt Kennlinien einer weiteren Ausführungsform des Verfahrens nach der Startphase in der zweiten Phase nach dem Anfangszeitpunkt TA, bei dem als Kurvenverlauf sägezahnartige Verläufe für die erste und die zweite Polarisationsspannung P1,P2 gewählt werden. In Figur 4a sind die Verläufe der ersten und der zweiten Polarisationsspannung P1, P2 dargestellt, die an den ersten und an den zweiten Aktor 1, 2 angelegt werden. Nach der Startphase liegen zu dem Anfangszeitpunkt TA die erste Polarisationsspannung P1 mit einem Maximalwert am ersten Aktor 1 an. Die zweite Polarisationsspannung P2 weist den Wert 0 auf.

Die erste Polarisationsspannung P1, die dem ersten Aktor 1 zugeführt wird, und die zweite Polarisationsspannung P2 sind in der Weise ausgebildet, dass die Summe der ersten und der zweiten Polarisationsspannung im wesentlichen zeitlich konstant bleibt. Dazu sind die Kurvenverläufe identisch, jedoch so zeitverschoben, dass die Summe (P1+P2) aus der ersten und der zweiten Polarisationsspannung im wesentlichen konstant ist.

Die Summe (P1+P2) der Polarisationsspannungen P1, P2 ist in Figur 4b dargestellt. Als Folge von der konstanten Summe der Polarisationsspannungen ist die Gesamtlänge L der Serienanordnung des ersten und des zweiten Aktors 1, 2, die sich aus der ersten Länge 11 und der zweiten Länge l2 des ersten bzw. des zweiten Aktors 1,2 ergibt, im Wesentlichen auch konstant. Die Gesamtlänge L ist in Figur 4c dargestellt. Geringe Schwankungen der Gesamtlänge L können hingenommen werden, so lange die auf den ersten und den zweiten Aktor einwirkende Vorspannkraft einen festgelegten Bereich nicht verlässt.

Zum Anfangszeitpunkt TA der zweiten Phase weisen der erste und der zweite Aktor 1, 2 eine Anfangslänge auf. Das erste und das zweite Halteelement 5, 6 sind einen durch die Steuereinheit 9 festgelegten Abstand voneinander beabstandet. Zudem wird über die Halteelemente 5, 6 eine gewünschte Vorspannkraft FG auf die Aktoren 1, 2 ausgeübt. An dem ersten Aktor 1 liegt zum Anfangszeitpunkt TA eine maximale Polarisierungsspannung Umax an. An dem zweiten Aktor 2 liegt zum Anfangszeitpunkt TA keine zweite Polarisierungsspannung P2 mit dem Wert 0 Volt an. Die Summe aus der ersten und der zweiten Polarisierungsspannung P1, P2 entspricht zum Anfangszeitpunkt dem maximalen Spannungswert Umax. Der Anfangszeitpunkt stellt bereits den ersten Verfahrensschritt nach der Startphase dar. Anschließend wird in einem zweiten Verfahrensschritt die zweite Polarisierungsspannung P2 auf einen höheren Wert angehoben. Der höhere und der niedrigere Wert der Polarisationsspannungen P1, P2 hängen von dem gewünschten Polarisationsvorgang ab.

In dem dargestellten Ausführungsbeispiel wird die erste Polarisationsspannung P1 linear von dem maximalen Spannungswert Umax bis auf den Wert 0 Volt zum ersten Zeitpunkt T1 gesenkt. Gleichzeitig wird die zweite Polarisationsspannung P2 von dem Wert 0 Volt linear bis zum ersten Zeitpunkt T1 auf den maximalen Spannungswert Umax erhöht. Während des ersten Verfahrensschrittes, d.h. zwischen dem Anfangszeitpunkt TA und dem ersten Zeitpunkt T1 entspricht die Summe der Polarisationsspannung P1 + P2 im Wesentlichen dem maximalen Spannungswert Umax. Je nach Ausführungsform kann die Summe der Polarisationsspannungen aber auch geringfügig schwanken, wie im Diagramm der Fig. 4b dargestellt ist.

Die Gesamtlänge L sollte idealerweise während des ersten Polarisationsschrittes, d.h. zwischen dem Anfangszeitpunkt TA und dem ersten Zeitpunkt T1 im Wesentlichen dem Startwert entsprechen. Jedoch können sowohl aufgrund von Ungenauigkeiten bei der Ansteuerung als auch durch Abweichungen der Materialeigenschaften des ersten und des zweiten Aktors 1, 2 geringfügige Änderungen oder Schwankungen der Gesamtlänge während des ersten Polarisationsschrittes auftreten. Die Vorspannkraft F, die in Figur 4d dargestellt ist, sollte während des ersten Verfahrensschrittes im Wesentlichen konstant bleiben. Aufgrund von Ungenauigkeiten bei der Ansteuerung oder unterschiedlichen Materialeigenschaften des ersten und des zweiten Aktors 1, 2 können auch geringe Abweichungen von dem Startwert FG der Vorspannkraft auftreten.

Anschließend wird in einem dritten Verfahrensschritt zwischen dem ersten und dem zweiten Zeitpunkt T1, T2 die erste und die zweite Polarisationsspannung P1, P2 konstant gehalten.

Anschließend wird in einem vierten Verfahrensschritt nach dem zweiten Zeitpunkt T2 die zweite Polarisationsspannung P2 linear bis zum dritten Zeitpunkt T3 auf den Wert 0 Volt abgesenkt. Gleichzeitig wird ausgehend vom zweiten Zeitpunkt T2 die erste Polarisationsspannung P1 ausgehend von dem Wert 0 Volt bis auf den maximalen Spannungswert Umax zum dritten Zeitpunkt T3 erhöht. Der symmetrische Wechsel der Polarisationsspannungen wird, wie aus Fig. 4a ersichtlich ist, eine festgelegte Zeitspanne wiederholt. Die festgelegte Zeitspanne wird experimentell ermittelt, wobei die Zeitspanne so lange gewählt wird, bis ein gewünschter Polarisationszustand des ersten und/oder des zweiten Aktors 1, 2 erreicht ist.

Je nach Anwendungsfall können die Zeitabschnitte, in denen die erste und die zweite Polarisationsspannung P1, P2 konstant gehalten werden, verkleinert oder auch vollständig weggelassen werden. Zudem können die Änderungen der ersten und der zweiten Polarisationsspannung P1, P2 anstelle einer linearen Änderung auch andere zeitliche Änderungsverhalten wie z.B. abgestufte Änderungen oder exponentielle Änderungen oder Änderungen beliebiger anderer Art aufweisen.

Da während der Startphase des Polarisationsvorganges eine Änderung der Gesamtlänge L des ersten und des zweiten Aktors 1, 2 auftritt, wird in einer vorteilhaften Ausführungsform der Abstand des ersten und des zweiten Halteelementes 5, 6 während der Startphase erhöht. Der Abstand steigt somit von einem Anfangswert bis zum Endwert am Ende der Startphase. Somit steigt auch die Gesamtlänge L während der Startphase von einem Startwert bis zu einem Endwert am Ende der Startphase.

Die Vorspannkraft, die auf den ersten und den zweiten Aktor 1, 2 einwirkt, sollte im Wesentlichen in einem festgelegten Wertebereich gehalten werden. Somit sind Schwankungen um den Startwert FG der Vorspannkraft zulässig. Am Ende des Polarisationsvorganges werden beide Polarisationsspannungen P1, P2 auf den Wert 0 gesenkt und die Vorspannkraft wird anschließend ebenfalls auf den Wert 0 reduziert.

Die Frequenz der Polarisationsspannungen, mit denen der erste und der zweite Aktor versorgt werden, hängt von den verwendeten Aktoren 1, 2 ab und kann im Bereich von einigen 100 Hertz liegen.

Die Erfindung wurde an einem Beispiel erläutert, bei dem in Serie zum ersten Aktor 1 ein zweiter Aktor 2 angeordnet ist, der im Wesentlichen identisch zum ersten Aktor 1 ausgebildet ist. Dies bietet den Vorteil, dass der erste und der zweite Aktor 1, 2 im Wesentlichen das gleiche Längenänderungsverhalten in Abhängigkeit von der angelegten Polarisationsspannung aufweist. Damit sind sowohl die zeitliche Änderung der Länge als auch die bei maximaler Spannung Umax sich ergebende maximale Auslenkung des ersten und des zweiten Aktors identisch. Somit können für die Polarisation des ersten und des zweiten Aktors im Wesentlichen gleiche Kurvenverläufe für die erste und die zweite Polarisationsspannung P1, P2 verwendet werden, die jedoch zeitlich gegeneinander verschoben sind. Durch dieses Verfahren können bei einem Polarisationsvorgang jeweils zwei nicht polarisierte Aktoren verwendet werden, so dass bei einem Polarisationsvorgang zwei Aktoren gleichzeitig polarisiert werden.

In einer weiteren Ausführungsform können auch unterschiedliche piezoelektrische Aktoren in Serie geschaltet werden. Dies erfordert jedoch einen höheren Aufwand bei der Polarisierung, da unterschiedliche Profile für die Polarisationsspannungen der zwei Aktoren verwendet werden müssen, um die Gesamtlänge L, die sich aus der Summe der Längen zwei Aktoren zusammensetzt während der Polarisation im Wesentlichen konstant zu halten. Bei zwei Aktoren, die unterschiedliche piezoelektrische Eigenschaften aufweisen, sind die entsprechenden Profile für die Polarisationsspannungen auch unterschiedlich ausgebildet. Um auch bei piezoelektrischen Aktoren mit unterschiedlichen piezoelektrischen Eigenschaften eine Begrenzung der Vorspannkraft F in dem gewünschten Bereich zu erhalten, kann auch eine Regelung der Polarisationsspannungen P1, P2 über die Erfassung der Vorspannkraft durch den Drucksensor 19 erfolgen. Dabei überwacht die Steuereinheit 9 mit dem Drucksensor 19 die an den ersten und den zweiten Aktor anliegende Druckspannung und regelt die Polarisationsspannungen P1, P2 der zwei Aktoren 1, 2 in der Weise, dass die Vorspannkraft F in dem gewünschten Bereich verweilt und trotzdem der erste und der zweite Aktor mit einer gepulsten Polarisationsspannung versorgt werden und eine remanente Polarisierung des ersten und des zweiten Aktors erreicht wird. Es können jedoch auch experimentell ermittelte Kurvenverläufe für die zwei Polarisationsspannungen verwendet werden.

Fig. 5 zeigt eine vorteilhafte Schaltungsanordnung für die Versorgung des ersten und des zweiten piezoelektrischen Aktors 1, 2 mit entsprechenden Polarisationsspannungen. In diesem Ausführungsbeispiel sind der erste Leiter 14 des ersten Aktors 1 mit einer ersten Spannung U1 und der zweite Leiter 15 des zweiten Aktors 2 mit einer dritten Spannung U3 verbunden. Die erste Spannung U1 und die dritte Spannung U3 sind jeweils konstant und weisen einen Potenzialunterschied auf. In dem gewählten Ausführungsbeispiel sind die erste und die dritte Spannung U1, U3 positiv, wobei die erste Spannung U1 einen minimalen Spannungswert Umin und die dritte Spannung U3 einen maximalen Spannungswert Umax aufweist. Der zweite Leiter 15 des ersten Aktors 1 und der erste Leiter des zweiten Aktors 2 sind elektrisch miteinander verbunden und werden von der Steuereinheit 9 mit einer Wechselspannung U2 versorgt, die zwischen dem maximalen Spannungswert Umax und dem minimalen Spannungswert Umin hin- und herspringt. Aufgrund der vorteilhaften Schaltungsanordnung reicht es aus, den ersten und den zweiten Aktor mit nur einer Wechselspannung und zwei konstanten, aber unterschiedlichen Spannungen zu versorgen. Auf diese Weise ist eine einfache und kostengünstige Spannungsversorgung während des Polarisationsvorganges möglich.

## Patentansprüche

1. Verfahren zum Polarisieren eines piezoelektrischen ersten Aktors (1), insbesondere für den Einsatz in einem Einspritzventil, wobei der erste Aktor (1) aus mehreren piezoelektrischen Schichten (11) besteht, die zwischen zwei Endflächen (16, 17) angeordnet sind, wobei jede Schicht (11) zwischen zwei Elektroden (12) angeordnet ist, wobei an die Elektroden (12) der Schichten (11) Spannungen mit sich ändernden Spannungswerten zur Polarisierung der Schichten (11) angelegt werden, wobei der erste Aktor (1) während der Polarisierung zwischen zwei Halteelementen (5, 6) angeordnet ist,
**dadurch gekennzeichnet,**
**dass** ein zweiter Aktor (2) in Serie zum ersten Aktor (1) angeordnet ist, dass der zweite Aktor (2) zwei Endflächen (16, 17) aufweist, wobei eine Endfläche (16) des ersten Aktors in Wirkverbindung mit einer Endfläche (17) des zweiten Aktors (2) steht, dass die zwei Aktoren (1, 2) über die äußeren Endflächen (17, 16) mit einer Druckspannung durch die Halteelemente (5, 6) beaufschlagt werden,
**dass** der erste und der zweite Aktor (1, 2) zur Polarisierung mit einer ersten bzw. mit einer zweiten sich ändernden Spannung versorgt werden, dass nach einer Startphase die Spannungen, die an die zwei Aktoren (1, 2) angelegt werden, in der Weise festgelegt sind, dass die Summe der zwei Spannungen zeitlich annähernd konstant ist, so dass die Gesamtlänge der zwei Aktoren (1, 2) trotz der durch die Spannungen erzeugten Längenänderungen des ersten und des zweiten Aktors (1, 2) zeitlich annähernd konstant gehalten wird.

2. Verfahren nach Anspruch 1, **dadurch gekennzeichnet, dass** die erste und die zweite Spannung während der Polarisierung zwischen Minimalwerten und Maximalwerten wechselt.

3. Verfahren nach einem der Ansprüche 1 oder 2, **dadurch gekennzeichnet, dass** während der Startphase der Maximalwert der sich ändernden ersten und zweiten Spannung von einem Anfangswert auf einen Endwert erhöht wird und dass sich nach der Startphase während der Polarisierung des ersten und/oder des zweiten Aktors (1,2) die Amplitude der ersten und/oder der zweiten Spannung zwischen dem Endwert und einem niedrigerem Wert zyklisch ändert.

4. Verfahren nach Anspruch 1, **dadurch gekennzeichnet, dass** als zweiter Aktor (2) ein noch nicht polarisierter Aktor verwendet wird und dadurch in einem Polarisationsvorgang zwei Aktoren (1, 2) gleichzeitig polarisiert werden.

5. Verfahren nach einem der Ansprüche 1 bis 4, **dadurch gekennzeichnet, dass** die erste und die zweite Spannung die gleiche Frequenz aufweisen, dass die erste und die zweite Spannung phasenverschoben an den ersten und den zweiten Aktor (1, 2) in der Weise angelegt werden, dass nach der Startphase die Summe aus der ersten und der zweiten Spannung im wesentlichen konstant bleibt.

6. Verfahren nach einem der Ansprüche 1 bis 5, **dadurch gekennzeichnet, dass** in einer festgelegten Polarisationsrichtung Spannungspulse verwendet werden, dass abwechselnd der erste und der zweite Aktor (1, 2) mit einem Spannungspuls versorgt wird, und dass gleichzeitig die Elektroden des zweiten bzw. des ersten Aktors (1, 2) auf ein einheitliches Potenzial gelegt werden.

7. Verfahren nach Anspruch 6, **dadurch gekennzeichnet, dass** die Spannungspulse in der Weise geformt sind, dass die zeitliche Änderung der Spannung an den Elektroden des ersten Aktors (1) gleich der zeitlichen Änderung der Spannung an den Elektroden des zweiten Aktors (2) ist, wobei die Spannung an einem Aktor (1) steigt und gleichzeitig am anderen Aktor (2) sinkt.

8. Verfahren nach einem der Ansprüche 3 bis 7, **dadurch gekennzeichnet, dass** ein Halteelement (6) gegenüber dem anderen Halteelement (5) bewegbar gelagert ist, dass eine sich während der Startphase des Polarisierungsvorganges einstellende Längenänderung des ersten und/oder des zweiten Aktors (1, 2) durch eine Verschiebung des bewegbaren Halteelementes (6) ausgeglichen wird.

9. Vorrichtung zum Polarisieren eines piezoelektrischen ersten Aktors (1), wobei der piezoelektrische erste Aktor (1) zwischen zwei Halteelemente (5, 6) einer Vorspannhalterung (7) eingespannt ist, wobei der piezoelektrische erste Aktor (1) über Steuerleitungen (10) mit einer Steuereinheit (9) verbunden ist, wobei über die Haltelemente (5, 6) eine Vorspannkraft an den ersten Aktor (1) anlegbar ist, **dadurch gekennzeichnet, dass** zwischen dem ersten Aktor (1) und einem Halteelement (5, 6) ein zweiter piezoelektrischer Aktor (2) angeordnet ist, der über zweite Steuerleitungen (21) mit der Steuereinheit (9) verbunden ist, dass die Steuereinheit (9) nach der Startphase während des Polarisierungsvorganges den ersten und den zweiten Aktor (1, 2) in der Weise mit Polarisationsspannungen mit sich ändernden Amplituden versorgt, dass sich die durch die Polarisationsspannungen erzeugten Längenänderungen der zwei Aktoren (1, 2) im Wesentlichen ausgleichen.

10. Vorrichtung nach Anspruch 9, **dadurch gekennzeichnet, dass** ein Drucksensor (19) vorgesehen ist, der die Vorspannkraft (F) erfasst und über Signalleitungen (20) an die Steuereinheit (9) weiterleitet, dass die Steuereinheit (9) die Polarisationsspannungen der zwei Aktoren (1, 2) in der Weise festlegt, dass sich die gemessene Vorspannkraft (F), die auf die zwei Aktoren (1, 2) einwirkt, während der Polarisation in einem vorgebbaren Wertebereich befindet.

11. Vorrichtung nach Ansprüche 9, **dadurch gekennzeichnet, dass** die zwei Halteelemente (5, 6) an einem Gehäuse (7) gehaltert sind, dass ein Halteelement (6) über eine Motorik (8) bewegbar am Gehäuse (7) gehaltert ist, dass die Motorik (8) über Steuerleitungen mit der Steuereinheit (9) verbunden ist, und dass die Steuereinheit (9) die Lage des bewegbaren Halteelementes (6) während der Startphase verändert, um die durch die Erhöhung der Amplituden der ersten und der zweiten Spannung entstehenden Längenänderungen des ersten und/oder des zweiten Aktors (1, 2) auszugleichen.

## Claims

1. Method for polarizing a piezoelectric first actuator (1), especially for use in an injection valve, with the first actuator (1) consisting of a number of piezoelectric layers (11) which are arranged between two end surfaces (16, 17), with each layer (11) being arranged between two electrodes (12), with changing voltage values for polarizing the layers (11) being applied to the electrodes (12) of the layers (11), with the first actuator (1) being arranged during polarization between two retaining elements (5, 6),
**characterised in that**
a second actuator (2) is arranged in series with the first actuator (1), that the second actuator (2) features two end surfaces (16, 17), with an end surface (16) of the first actuator having an effective connection to an end surface (17) of the second actuator (2), that a compressive stress is applied to the two actuators (1, 2) via the outer end surfaces (17, 16) through the retaining elements (5, 6), that the first and the second actuator (1, 2) are supplied for polarization with a first or with a second changing voltage, that after a start phase the voltages which are applied to the two actuators (1, 2) are defined in a manner whereby the sum of the two voltages is approximately constant over time, so that the total length of the two actuators (1, 2), despite the changes in length of the first and the second actuator (1, 2) generated by the voltages are kept approximately constant over time.

2. Method in accordance with claim 1, **characterised in that** the first and the second voltage switches during the polarization between minimum values and maximum values.

3. Method in accordance with one of the claims 1 or 2,
**characterised in that**, during the start phase, the maximum value of the changing first and second voltage is increased from an initial value to an end value, and that after the start phase during the polarization of the first and/or of the second actuator (1, 2) the amplitude of the first and/or the second voltage changes cyclically between the end value and a lower value.

4. Method in accordance with claim 1, **characterised in that** a not yet polarised actuator is used as the second actuator (2) and thereby two actuators (1, 2) are polarised simultaneously in one polarization process.

5. Method in accordance with one of the claims 1 to 4, **characterised in that** the first and the second voltage have the same frequency, that the first and the second voltage are applied with phase offset to the first and the second actuator (1, 2) in such a way that after the start phase the sum of the first and the second voltage essentially remains constant.

6. Method in accordance with one of the claims 1 to 5, **characterised in that** voltage pulses are used in a defined polarization direction, that the first and the second actuator (1, 2) are supplied with a voltage pulse, and that the electrodes of the second or the first actuator (1, 2) are simultaneously set to a uniform potential.

7. Method in accordance with claim 6, **characterised in that** the voltage pulses are formed in the manner such that the change over time of the voltage at the electrodes of the first actuator (1) is the same as the change over time of the voltage at the electrodes of the second actuator (2), with the voltage rising at one actuator (1) and simultaneously falling at the other actuator (2).

8. Method in accordance with one of the claims 3 to 7, **characterised in that** a retaining element (6) is supported to allow movement in relation to the other retaining element (5), that a change in length occurring during the start phase of the polarization process is compensated for by the first and/or of the second actuator (1, 2) by a shifting of the movable retaining element (6).

9. Device for polarizing a piezoelectric first actuator (1), with the piezoelectric first actuator (1) being tensioned between two retaining elements (5, 6) of a pretensioning holder (7), with the piezoelectric first actuator (1) being connected via control lines (10) with a control unit (9) with a pretensioning force being able to be applied to the first actuator (1) via the retaining elements (5, 6), **characterised in that** a second piezoelectric actuator (2) is arranged between the first actuator (1) and a retaining element (5, 6) which is connected via second control lines (21) to the control unit (9), that the control unit (9) after the start phase during the polarization process supplies the first and the second actuator (1, 2) with polarization voltages with changing amplitudes in such as way that the length changes of the two actuators (1, 2) generated through the polarization voltages essentially balance out.

10. Device in accordance with claim 9, **characterised in that** a pressure sensor (19) is provided which records the pretensioning force (F) and forwards it via signal lines (20) to the control unit (9), that the control unit (9) defines the polarization voltages of the two actuators (1, 2) such that the measured pretension force (F) which acts on the two actuators (1, 2) lies within a specified range of values during the polarization.

11. Device in accordance with claim 9, **characterised in that** the two retaining elements (5, 6) are mounted on a housing (7), that one retaining element (6) is mounted via a motor system (8) movably on the housing (7), that the motor system (8) is connected via control leads to the control unit (9) and that the control unit (9) changes the position of the moveable retaining element (6) during the start phase, in order to compensate for the changes in length arising from the increases in amplitude of the first and the second voltage or of the first and/or of the second actuator (1, 2).

## Revendications

1. Procédé pour polariser un premier actionneur piézoélectrique (1), en particulier pour une mise en oeuvre dans une soupape d'injection, dans lequel le premier actionneur (1) se compose de plusieurs couches piézoélectriques (11) qui sont disposées entre deux surfaces d'extrémité (16, 17), dans lequel chaque couche (11) est disposée entre deux électrodes (12), dans lequel on applique aux électrodes (12) des couches (11) des tensions avec des valeurs de tension variables pour la polarisation des couches (11), dans lequel, pendant la polarisation, le premier actionneur (1) est disposé entre deux éléments de retenue (5, 6),
**caractérisé en ce qu'**un deuxième actionneur (2) est disposé en série avec le premier actionneur (1), **en ce que** le deuxième actionneur (2) présente deux surface d'extrémité (16, 17), une surface d'extrémité (16) du premier actionneur se trouvant en relation active avec une surface d'extrémité (17) du deuxième actionneur (2), **en ce que** les deux actionneurs (1, 2) sont sollicités par l'intermédiaire des surfaces d'extrémité extérieures (17, 16) avec une contrainte de compression par les éléments de retenue (5, 6),
**en ce que**, pour la polarisation, le premier et le deuxième actionneurs (1, 2) sont alimentés avec une première ou une deuxième tension variable, **en ce qu'**après une phase de démarrage, les tensions qui sont appliquées aux deux actionneurs (1, 2) sont fixées de telle sorte que la somme des deux tensions est approximativement constante dans le temps, de sorte que la longueur totale des deux actionneurs (1, 2) peut être maintenue approximativement constante dans le temps malgré les variations de longueur du premier et du deuxième actionneur (1, 2), générées par les tensions.

2. Procédé selon la revendication 1, **caractérisé en ce que**, pendant la polarisation, la première et la deuxième tension alternent entre des valeurs minimales et des valeurs maximales.

3. Procédé selon l'une quelconque des revendications 1 ou 2, **caractérisé en ce que** pendant la phase de démarrage, la valeur maximale de la première et deuxième tension variable est augmentée d'une valeur initiale à une valeur finale, et **en ce qu'**après la phase de démarrage pendant la polarisation du premier et/ou du deuxième actionneurs (1, 2), l'amplitude de la première et/ou de la deuxième tension varie de façon cyclique entre la valeur finale et une valeur inférieure.

4. Procédé selon la revendication 1, **caractérisé en ce que** l'on utilise comme deuxième actionneur (2) un actionneur pas encore polarisé, et **en ce que** deux actionneurs (1, 2) sont ainsi polarisés en même temps dans une seule opération de polarisation.

5. Procédé selon l'une quelconque des revendications 1 à 4, **caractérisé en ce que** la première et la deuxième tension présentent la même fréquence, **en ce que** la première et la deuxième tension sont appliquées avec un décalage de phase au premier et au deuxième actionneur (1, 2) de telle sorte qu'après la phase de démarrage la somme de la première et de la deuxième tension reste substantiellement constante.

6. Procédé selon l'une quelconque des revendications 1 à 5, **caractérisé en ce que** dans une direction de polarisation définie, des impulsions de tension sont utilisées, **en ce qu'**en alternance le premier et le deuxième actionneur (1, 2) sont alimentés avec une impulsion de tension, et **en ce qu'**en même temps, les électrodes du deuxième ou du premier actionneur (1, 2) sont mises sur un potentiel homogène.

7. Procédé selon la revendication 6, **caractérisé en ce que** les impulsions de tension sont formées de telle sorte que la variation temporelle de la tension aux électrodes du premier actionneur (1) est égale à la variation temporelle de la tension aux électrodes du deuxième actionneur (2), la tension montant au niveau d'un actionneur (1) et descendant en même temps au niveau de l'autre actionneur (2).

8. Procédé selon l'une quelconque des revendications 3 à 7, **caractérisé en ce qu'**un élément de retenue (6) est monté de façon mobile par rapport à l'autre élément de retenue (5), **en ce qu'**une variation de longueur du premier et/ou du deuxième actionneur (1, 2), apparaissant pendant la phase de démarrage de l'opération de polarisation, est compensée par un décalage de l'élément de retenue mobile (6).

9. Dispositif pour polariser un premier actionneur piézoélectrique (1), dans lequel le premier actionneur piézoélectrique (1) est serré entre deux éléments de retenue (5, 6) d'une fixation de précontrainte (7), dans lequel le premier actionneur piézoélectrique (1) est relié à une unité de commande (9) par l'intermédiaire de lignes de commande (10), dans lequel une force de précontrainte peut être appliquée au premier actionneur (1) par l'intermédiaire des éléments de retenue (5, 6), **caractérisé en ce qu'**entre le premier actionneur (1) et un élément de retenue (5, 6), un deuxième actionneur piézoélectrique (2) est disposé qui est relié à l'unité de commande (9) par l'intermédiaire de deuxièmes lignes de commande (21), **en ce que** l'unité de commande (9) alimente après la phase de démarrage pendant l'opération de polarisation le premier et le deuxième actionneurs (1, 2) de telle sorte avec des tensions de polarisation ayant des amplitudes variables que les variations de longueur des deux actionneurs (1, 2), générées par les tensions de polarisation, s'équilibrent substantiellement.

10. Dispositif selon la revendication 9, **caractérisé en ce qu'**un capteur de pression (19) est prévu qui détecte la force de précontrainte (F) et la retransmet par l'intermédiaire de lignes d'acheminement de signal (20) à l'unité de commande (9), **en ce que** l'unité de commande (9) fixe les tensions de polarisation des deux actionneurs (1, 2) de telle sorte que la force de précontrainte mesurée (F) qui agit sur les deux actionneurs (1, 2) se trouve pendant la polarisation dans une plage de valeurs prédéfinissable.

11. Dispositif selon la revendication 9, **caractérisé en ce que** les deux éléments de retenue (5, 6) sont retenus dans un boîtier (7), **en ce qu'**un élément de retenue (6) est retenu sur le boîtier (7) de façon mobile par l'intermédiaire d'un dispositif moteur (8), **en ce que** le dispositif moteur (8) est relié à l'unité de commande (9) par des lignes de commande, et **en ce que** l'unité de commande (9) modifie la position de l'élément de retenue (6) mobile pendant la phase de démarrage afin de compenser les variations de longueur du premier et/ou du deuxième actionneur (1, 2), provoquées par l'augmentation des amplitudes de la première et de la deuxième tension.
